# EUROPEAN PATENT SPECIFICATION

(11) **EP 1 082 882 B1**
(45) Date of publication and mention of the grant of the patent: **31.10.2007**
(21) Application number: 00923062.4
(22) Date of filing: 18.01.2000
(51) Int. Cl.: H05K 1/16, H01L 21/302

(54) **METHOD OF MANUFACTURING RESISTORS**
VERFAHREN ZUR HERSTELLUNG VON WIDERSTÄNDEN
PROCEDE DE FABRICATION DE RESISTANCES

(30) Priority: 17.03.1999 US 270992
(43) Date of publication of application: 14.03.2001
(73) Proprietor: MOTOROLA, INC., Schaumburg, IL 60196 (US)
(72) Inventor: DUNN, Gregory, J., Arlington Heights, IL 60005 (US); ZHANG, Min-Xian, Algonquin, IL 60102 (US); SAVIC, John, Downers Grove, IL 60515 (US)
(74) Representative: Cross, Rupert Edward Blount
(86) International application number: PCT/US2000/001081
(87) International publication number: WO 2000/056128

(56) References cited:
- EP-A- 0 364 095
- US-A- 2 662 957
- US-A- 4 808 967
- US-A- 5 173 150
- US-A- 5 723 359
- US-A- 5 976 392
- US-A- 6 021 050

## Description

### BACKGROUND OF THE INVENTION

The present invention generally relates to printed circuit boards and their fabrication. More particularly, the invention relates to printed circuit boards having both low and high value integral resistors and to the method of making these boards.

Both low value resistors having electrical resistances of a few hundred ohms or less per square, and high value resistors having resistances over 1 kiloohms per square are generally required on printed circuit boards. Optimally, both high and low value resistors could be incorporated during the printing and etching processes conventionally used to make such boards.

High and low value resistors have been formed on circuit boards by screen printing polymer thick film inks onto predetermined regions of a circuit board. Generally, these regions are terminated directly onto copper traces. A single thick film resistor ink cannot be used to cover the 10 ohm to 200 kiloohm range of resistors in a typical circuit. Using multiple inks requires multiple print and cure steps. Screen printing is also a relatively crude process, and it is difficult to print resistor ink onto thick (18-36 micrometers) copper terminals and obtain the exact resistance desired. In some cases, it is preferable to employ chip resistors with precision resistances even though they are more expensive to use.

A further drawback of polymer thick film resistors is that their resistances tend to increase under temperature and humidity stress, probably due to corrosion at the polymer-copper terminal interfaces. This corrosion can be reduced by applying a finish of a more oxidation-resistant metal such as nickel, gold, or silver to the copper. Clearly, this adds process steps and cost.

Alternatively, the resistance increase can be reduced by employing a thinner copper layer, but this conflicts with the need for relatively thick copper to form low resistance conductor traces throughout the rest of the circuit. Polymer thick film resistors also exhibit impedance roll off at high frequencies making them unsuitable for low value resistors used in the RF portions of a circuit board.

Low value resistors having the precise resistances required for radio frequency portions of a printed circuit board can be formed by a conventional process of applying a conductor and resistant metal alloy bilaminate, resistant metal alloy layer down, onto a suitable dielectric substrate. The top conductor layer is printed and the conductor etched away except in the defined regions where resistors are to be located on the board. The resistant metal alloy layer, which was beneath the etched metal regions, is then itself etched away. The conductor which overlays the resistant metal alloy in the defined regions is then printed and etched a second time to define resistor lengths and to form the resistors' terminals. While relatively precise resistor values can be obtained by this process, it is limited to making resistors with resistances of a few hundred ohms or less.

From the above, it can be seen that neither of the two most widely practiced technologies for making printed circuit boards with integral resistors is entirely satisfactory: metal alloy resistors being limited in resistance range, and polymer thick film resistors lacking both precision and stability. Accordingly, a need exists for an economical method for making printed circuit boards comprising both high and low value resistors. More particularly, there is a need for concomitantly producing both low and high value resistors, with predictable and stable resistances, on printed circuit boards using existing manufacturing equipment.

EP 0 364 095 describes a printed circuit board in which a thick film resistor is formed over low resistance electrical contacts with conductors formed over the low resistance electrical contacts to form a resistor with high resistivity. The material used for the low-resistance electrical contacts is also used to form low-value resistors.

### SUMMARY OF THE INVENTION

In accordance with an aspect of the present invention there is provided a method for making a printed circuit board according to the accompanying claims.

A process is provided for concurrently forming both high and low value resistors on a printed circuit board.

The method of this invention preferably entails applying a first layer of a low resistance material having a sheet resistance less than about 500 ohms per square onto a dielectric substrate in a predetermined thickness and pattern. The pattern defines the electrical lengths and widths of the low value resistors as well as pairs of terminal electrode pads for the high value resistors. A second layer of a high resistance material having a sheet resistance of about 1 kiloohm per square or greater is applied between and in contact with the top surfaces of the facing ends of each member of the terminal pad pairs. The fixed lengths, widths and thicknesses of the patterned high resistance material determine the values of the high value resistors. Conductive metal terminals are provided at the ends of the low value resistors and at the distal ends of the pad pairs to complete the resistors. The resistors and substrate may be coated with a dielectric material. This layer isolates the resistors from the environment and can serve as a base upon which to build additional layers of circuitry.

### BRIEF DESCRIPTION OF THE DRAWINGS

Figure 1 is a top view of a low value resistor and a high value resistor on a dielectric substrate in accordance with the invention.
Figure 2 is a cross-sectional view along A-A of Figure 1.
Figure 3 is a cross-sectional view of low value and a high value resistor embedded in a dielectric layer in accordance with the invention.

### DETAILED DESCRIPTION

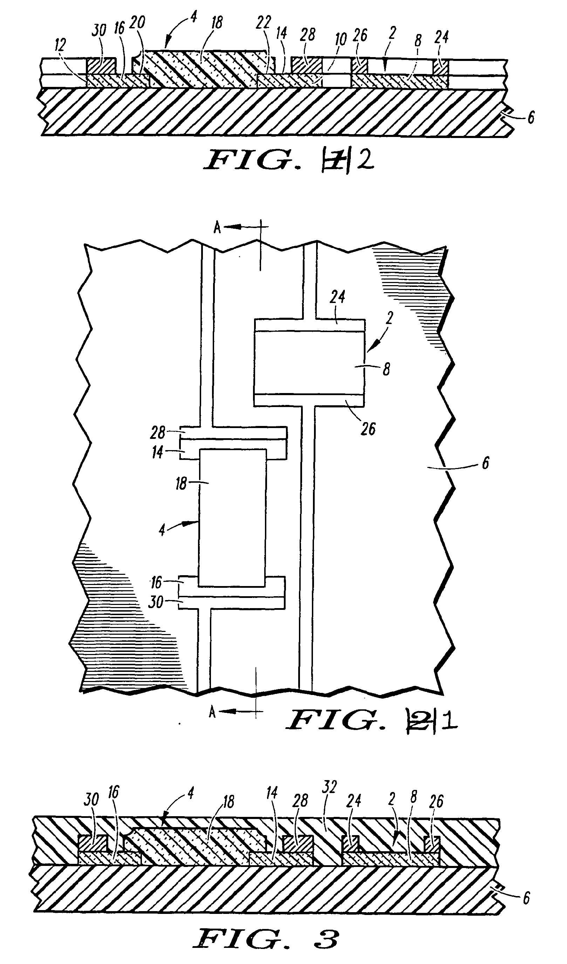

Referring to Figure 1, a top view of a low value resistor 2 and a high value resistor 4 on a dielectric substrate 6 are represented. Substrate 6 may be any suitable material such as a printed circuit board, a flexible circuit, a ceramic or silicon substrate, another dielectric layer of a multilayer circuit or other such suitable substrates which are known to those skilled in the art.

With further reference to Figure 2, a first patterned region 8 of a low resistivity material has been applied to substrate 6. Additional patterned regions 10 and 12 have been applied to substrate 6 forming first and second terminal electrode pads 14 and 16, respectively. Preferred low resistivity materials include nickel or nickel alloys such as NiP or NiCu, or any other alloy of metals such as gold, silver or palladium which have suitable resistances of from about 1 to 500 ohms per square and which can be applied by conventional printed circuit board manufacturing processes. Such processes include electroless plating and immersion coating techniques or patterning an etchable low resistivity layer. A suitable such etchable nickel alloy is the NiP layer of a dielectric-NiP-Cu trilaminate material, Ohmegaply^{™}, sold by Ohmega Technologies. The low resistivity patterned material preferably has a thickness in the range of about 0.02 to 10 micrometers.

High value resistor 4 is formed by applying a patterned region 18 of a material having a resistance of at least a kiloohm per square and preferably in the range of one to 100 kiloohms per square. Region 18 extends between electrode pads 10 and 12 over substrate 6 and onto surfaces 20 and 22 of electrode pads 12 and 10, respectively. The resistance of resistor 4 is determined by the length, thickness, and width of region 18 and the distance separating electrode pads 12 and 10.

A preferred high resistivity material is a polymer thick film formed by depositing and curing a polymer thick-film resistive ink. The resistive ink can be applied by screen printing, stenciling or any other technique capable of depositing a controlled amount of ink on substrate 6 and electrode pads 10 and 12. Suitable ink compositions are polymer thick-film inks containing particulate conductive fillers dispersed in a polymeric matrix. A preferred composition known in the art contains carbon particles as the filler dispersed in a heat-curable phenolic resin. The high resistivity material typically has a thickness ranging from approximately ten to approximately twenty micrometers.

Referring to Figure 3, resistors 2 and 4 may be embedded applying a coating 32 over the assembly with a dielectric material such as an epoxy or other suitable resin.

To complete low value resistor 2, first and second conductive terminals 24 and 26 of copper or other suitable metal are provided to opposite ends of patterned region 8. To complete high value resistor 4, conductive terminals 28 and 30 are provided.

Advantages of the subject method and product are many. For example, the bonds between both the metal terminals and the thick film polymer resistors and the underlying electrode pads 14 and 16 are more stable than conventional copper-thick film polymer bonds. In effect, an ideal electrode, thin and composed of a corrosion resistant metal, is provided simultaneously with low value resistor fabrication.

A further advantage is that substantially precise values for high value resistors such as 4 can be achieved using otherwise imprecise screen printing processes. Because the resistor body 18 terminates on the thin electrode pads 14 and 16 rather than overlapping a thick conductive metal terminal, the resistor value can be more reliably and reproducibly determined. It is also preferred to make pads 14 and 16 slightly wider than a resistor 4 to provide some margin for placement. In a kiloohm or greater value resistor, the additional resistance provided by pads 14 and 16 is negligible.

Because the same low resistance alloy material is used to form the low value resistor 2 and the terminal pads 14 and 16 for high value resistor 16, additional processing steps are not required to form the low and high value resistors on the same circuit board. This substantially reduces cost and potential thickness of a printed circuit board. Moreover, the full value range of resistors can be incorporated simply by sizing the print region for low value resistors and adjusting the length and width of high value thick film polymer resistors. These features assist the board's designers in fitting all desired circuit components on the same board. Additionally, because the overall layer thickness of the layer containing resistors on a multiple layer board is relatively thin, an applied dielectric embedding or potting coating 32 may serve as a base for the build up of additional layers on a circuit board.

In accordance with a most preferred embodiment, a printed circuit board comprising a low value resistor and a high value resistor integrally formed thereon can be made as follows.

A sheet of Ohmegaply^{™}, sold by Ohmega Technologies is provided. It comprises a dielectric substrate, a plated nickel-phosphorous layer containing up to 30% phosphorous and having a resistance of up to 500 ohms/square, and a conductive copper overlayer. The low resistance material, for example the plated nickel-phosphorous layer, and the conductive layer can be applied to the dielectric substrate as a laminate.

The copper layer is printed and etched to define the length and width of the low value resistor, the extent of the terminal electrode pads for the high value resistor, and the terminals for both. The exposed NiP layer is then etched away to the substrate. The remaining copper layer is further etched to determine the value of the low value resistor: Concurrently, copper is etched from a portion of the top surface of each electrode pad to accommodate the placement of the high value resistor body between them.

The high value resistor is formed by screen printing a suitable thick film polymer ink between and in contact with the surface of the terminal pads and curing it.

Optionally, the board may be further coated with a dielectric protective layer such as epoxy and cured.

While our invention has been described in terms of preferred embodiments, other forms could be readily adapted by those skilled in the art. For example other alloys and materials having suitable electrical properties could be used, or different methods of applying materials to a controlled region of a circuit board utilized. Accordingly, the scope of the invention is to be limited only in accordance with the following claims.

## Claims

1. A method of making a printed circuit board comprising a low value resistor (2) and a high value resistor (4), said low and high value resistors being integrally formed on the board, the method comprising the steps of:
applying a laminate to a dielectric substrate (6), the laminate comprising a first layer of a low resistance material and second layer of a conductive terminal metal, said first layer being adjacent to said substrate (6) ;
removing predetermined regions of said first and second laminate layers such that
said low value resistor (2) is formed having conductive metal terminals (24,26), and first (14) and second (16) terminal electrode pads of said low resistance material are formed in spaced relation for the application of high resistivity material (18) therebetween and conductive metal terminals (28,30) are formed at the distal ends of said terminal pads (14,16); and
applying a layer of a high resistance material (18) between and in contact with said first (14) and second (16) terminal pads to form said high value resistor.

2. The method of claim 1 wherein the first laminate layer comprises an electroplated nickel-phosphorous alloy.

3. The method of claim 1 wherein the low resistivity material has a sheet resistance of 1 to 500 ohms per square and the high resistivity material has a sheet resistance of 1 to 100 kilo ohms per square.

4. The method of claim 1 wherein the low resistance material is a nickel alloy.

5. The method of claim 1 wherein the high resistivity material is a thick film polymer ink.

6. A method of making a printed circuit board comprising a low value resistor (2) and a high value resistor (4), said low and high value resistors being integrally formed on the board, the method comprising the steps of:
providing a dielectric substrate (6) ;
applying a first layer of a low resistance material on said substrate ; applying a second layer of an etchable conductive metal over said first layer ;
etching said conductive metal to define the length and width of the low value resistor (2) and the terminals (24,26) therefore and to define a pair of first and second terminal electrode pads (14,16) and terminals (28,30) for the high value resistor (4) ;
removing said low resistance material exposed by said etching;
etching said remaining conductive metal such that said low value resistor (2) is formed and said first and second terminal electrode pads (14,16) are formed in spaced relation for the application of high resistivity layer (18) thereon and therebetween; and
applying a high resistivity material (18) between and in contact with said first and second terminal electrode pads (14,16) to form said high value resistor (4).

## Patentansprüche

1. Verfahren zur Herstellung einer gedruckten Schaltung, welche einen Widerstand (2) mit einem geringen Wert und einen Widerstand (4) mit einem hohen Wert aufweist, wobei die Widerstände mit dem geringen und mit dem hohen Wert fest eingebaut auf der Leiterplatte ausgebildet sind, wobei das Verfahren die folgenden Schritte umfasst:
Aufbringen eines Laminats auf ein dielektrisches Substrat (6), wobei das Laminat eine erste Schicht eines Werkstoffs mit geringem Widerstand und eine zweite Schicht eines leitfähigen Anschlussstellenmetalls aufweist, wobei die erste Schicht benachbart zum Substrat (6) angeordnet ist;
Entfernen vorher festgelegter Bereiche der ersten und zweiten Laminatschicht, so dass
der Widerstand (2) mit dem geringen Wert mit leitfähigen Metallanschlussstellen (24, 26) sowie ersten (14) und zweiten (16) Anschlusselektrodenpads aus dem Werkstoff mit geringem Widerstand in beabstandeter Relation für das Aufbringen des Werkstoffs (18) mit hohem spezifischen Widerstand dazwischen gebildet ist, und dass die leitfähigen Metallanschlüsse (28, 30) an den entfernten Enden des Anschlusspads (14, 16) ausgebildet sind; und
Aufbringen einer Schicht eines Werkstoffs (18) mit hohem spezifischen Widerstand zwischen und in Kontakt mit den ersten (14) und zweiten (16) Anschlusspads stehend, zur Bildung des Widerstands mit einem hohen Wert.

2. Verfahren nach Anspruch 1, **dadurch gekennzeichnet, dass** die erste Laminatschicht eine elektroplattierte Nickelphosphorlegierung aufweist.

3. Verfahren nach Anspruch 1, **dadurch gekennzeichnet, dass** der Werkstoff mit geringem spezifischen Widerstand einen Flächenwiderstand von 1 bis 500 Ohm pro Quadrat und der Werkstoff mit hohem spezifischen Widerstand einen Flächenwiderstand von 1 bis 100 Kiloohm pro Quadrat hat.

4. Verfahren nach Anspruch 1, **dadurch gekennzeichnet, dass** der Werkstoff mit niedrigem spezifischen Widerstand eine Nickellegierung ist.

5. Verfahren nach Anspruch 1, **dadurch gekennzeichnet, dass** der Werkstoff mit hohem spezifischen Widerstand eine Dickschicht-Polymertinte ist.

6. Verfahren zur Herstellung einer gedruckten Schaltung, welche einen Widerstand (2) mit einem geringen Wert und einen Widerstand (4) mit einem hohen Wert aufweist, wobei die Widerstände mit dem geringen und mit dem hohen Wert fest eingebaut auf der Leiterplatte ausgebildet sind, wobei das Verfahren die folgenden Schritte umfasst:
Bereitstellen eines dielektrischen Substrats (6);
Aufbringen einer ersten Schicht eines Werkstoffs mit einem geringen Widerstand auf dem Substrat; Aufbringen einer zweiten Schicht eines ätzbaren leitfähigen Metalls über der ersten Schicht;
Ätzen des leitfähigen Metalls zum Festlegen der Länge und Breite des Widerstands (2) mit dem geringen Wert und der Anschlussstellen (24, 26) für diesen, und zum Festlegen eines Paars von ersten und zweiten Anschlusselektrodenpads (14, 16) und Anschlüssen (28, 30) für den Widerstand (4) mit dem hohen Wert;
Entfernen des durch das Ätzen freigelegten Werkstoffs mit geringem spezifischen Widerstand;
Ätzen des verbleibenden leitfähigen Metalls, so dass der Widerstand (2) mit dem geringen Wert gebildet wird und die ersten und zweiten Anschlusselektrodenpads (14, 16) in beabstandeter Relation für das Aufbringen der Schicht mit hohem spezifischen Widerstand (18) darauf und dazwischen gebildet werden; und
Aufbringen eines Werkstoffs (18) mit hohem spezifischen Widerstand zwischen und in Kontakt mit den ersten und zweiten Anschlusselektrodenpads (14, 16) stehend, zur Bildung des Widerstands (4) mit dem hohen Wert.

## Revendications

1. Procédé de fabrication d'une carte de circuit imprimé comprenant une résistance à faible valeur (2) et une résistance à valeur élevée (4), lesdites résistances à valeurs faible et élevée étant formées de manière intégrée sur la carte, le procédé comprenant les étapes consistant à :
appliquer un stratifié sur un substrat diélectrique (6), le stratifié comprenant une première couche d'un matériau à faible résistance et une seconde couche d'un métal de borne conducteur, ladite première couche étant adjacente audit substrat (6);
enlever des régions prédéterminées desdites première et seconde couches de stratifié de sorte que
ladite résistance à faible valeur (2) est formée de manière à avoir des bornes en métal conducteur (24, 26) et des premier (14) et second (16) plots d'électrode de borne dudit matériau à faible résistance sont formés en relation espacée pour l'application du matériau à résistivité élevée (18) entre ceux-ci et des bornes en métal conducteur (28, 30) sont formées aux extrémités distales desdits plots de borne (14, 16); et
appliquer une couche de matériau à résistance élevée (18), entre et en contact avec lesdits premier (14), et second (16) plots de borne pour former ladite résistance à valeur élevée.

2. Procédé de la revendication 1 dans lequel la première couche de stratifié comprend un alliage de nickel phosphoreux électrolytique.

3. Procédé de la revendication 1 dans lequel le matériau de faible résistivité a une résistance de couche de 1 à 500 ohms par carré et le matériau de résistivité élevée a une résistance de couche de 1 à 100 kiloohms par carré.

4. Procédé de la revendication 1 dans lequel le matériau à faible résistance est un alliage de nickel.

5. Procédé de la revendication 1 dans lequel le matériau de résistivité élevée est une encre polymère en couche épaisse.

6. Procédé de fabrication d'une carte de circuit imprimé comprenant une résistance à faible valeur (2) et une résistance à valeur élevée (4), lesdites résistances à valeur faible et élevée étant formées de manière intégrée sur la carte, le procédé comprenant les étapes consistant à :
produire un substrat diélectrique (6);
appliquer une première couche d'un matériau à faible résistance sur ledit substrat; appliquer une seconde couche d'un métal conducteur sensible à la gravure sur ladite première couche;
graver ledit métal conducteur pour définir la longueur et la largeur de la résistance à faible valeur (2) et les bornes (24, 26) en conséquence et définir une paire de premier et second plots d'électrode de borne (14, 16) et de bornes (28, 30) pour la résistance à valeur élevée (4);
enlever ledit matériau à faible résistance exposé par ladite gravure;
graver ledit métal conducteur résiduel de sorte que ladite résistance à faible valeur (2) est formée et lesdits premier et second plots d'électrode (14, 16) sont formés en relation espacée pour l'application d'une couche de résistivité élevée (18) sur et entre ceux-ci; et
appliquer un matériau de résistivité élevée (18) entre et en contact avec lesdits premier et second plots d'électrode de borne (14, 16) pour former ladite résistance à valeur élevée (4).
